(19) Europäisches Patentamt
European Patent Office
Office européen des brevets

(11) **EP 4 653 952 A1**

(12) **EUROPEAN PATENT APPLICATION**

(43) Date of publication:
**26.11.2025 Bulletin 2025/48**

(21) Application number: **24176931.4**

(22) Date of filing: **21.05.2024**

(51) International Patent Classification (IPC):
*G03F 7/00* *(2006.01)*

(52) Cooperative Patent Classification (CPC):
**G03F 7/70783; G03F 7/70258; G03F 7/70358; G03F 7/70875**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• **BUTLER, Hans
5500 AH Veldhoven (NL)**
• **VAN DER WIJST, Marc, Wilhelmus, Maria
5500 AH Veldhoven (NL)**
• **VAN SCHOOT, Jan, Bernard, Plechelmus
5500 AH Veldhoven (NL)**

(74) Representative: **ASML Netherlands B.V.
Corporate Intellectual Property
P.O. Box 324
5500 AH Veldhoven (NL)**

(54) **IMPROVEMENTS TO LITHOGRAPHIC METHODS AND APPARATUS**

(57) A method for determining a value of one or more movement parameters for an imaging system (e.g. of a lithographic apparatus) that is for forming one or more images of an object (e.g. a reticle) on a substrate (e.g. a wafer) using radiation is disclosed. The method comprises: determining a deformation of the substrate due to exposure to the radiation; and determining a value of one or more movement parameters of at least one optical element of the imaging system during the formation of one of the one or more images, the value of the one or more movement parameters being determined in dependence on the determined deformation of the substrate due to the exposure to the radiation (e.g. such that a deformation of the image during the formation of that image at least partially corrects for a deformation of the substrate due to exposure to the radiation).

100

110

120

**FIG. 2**

EP 4 653 952 A1

**Description**

FIELD

The present invention relates to a method for determining a value of one or more movement parameters for an imaging system that is for forming an image of an object on a substrate. The imaging system may comprise the projection optics of a lithographic apparatus, the object may comprise a reticle and the substrate may comprise a resist-coated silicon wafer. The present invention also relates to an exposure method that uses the determined value(s) of one or more movement parameters of the imaging system. The present invention also relates to a lithographic apparatus operable to carry out one or more of these new methods. The present invention may have particular application to extreme ultraviolet (EUV) lithography.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern from a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm. Note that the term EUV radiation is not intended to be limited to wavelengths within the range 2-20 nm and may have slightly larger or smaller wavelengths.

Radiation that has been patterned by the patterning device is focussed onto the substrate using a projection system. The projection system may introduce optical aberrations, which may cause the image formed on the substrate to deviate from a desired image (for example a diffraction limited image of the patterning device). In particular, optical aberrations may distort the aerial image formed by the projection system such that it is distorted on the wafer, causing printing errors. It is known to measure optical aberrations (for example periodically) and to adjust the projection optics. It is also known to use such measurement to at least partially correct for such optical aberrations in an attempt to minimize optical aberrations.

It may be desirable to provide methods and apparatus for reducing, or at least partially correcting for, printing errors made by a projection system that at least partially addresses one or more problems associated with prior art arrangements whether such problems are identified herein or otherwise.

SUMMARY

According to a first aspect of the present disclosure there is provided a method for determining a value of one or more movement parameters for an imaging system that is for forming one or more images of an object on a substrate using radiation, the method comprising: determining a deformation of the substrate due to exposure to the radiation; and determining a value of one or more movement parameters of at least one optical element of the imaging system during the formation of one of the one or more images, the value of the one or more movement parameters being determined in dependence on the determined deformation of the substrate due to the exposure to the radiation.

The method of the first aspect of the present disclosure is advantageous, as now discussed. The method may have particular application to an imaging system of a lithographic apparatus. The lithographic apparatus may be a scanning lithographic apparatus (also referred to as a scanner) and the image(s) (of a reticle) may be formed during a scanning exposure. In such an exposure, the wafer may be moved in a scanning direction through a wafer-level illumination region (also referred to as an illumination slit or slit).

Within a lithographic apparatus, the radiation beam used to expose the wafer may cause (time-dependent) thermal deformation of the wafer. In turn, this can cause a mismatch between a shape of the wafer and the image formed by the projection system PS and the, resulting in printing errors and degrading optical performance. Advantageously, the method according to the first aspect allows for such thermal deformation of the wafer to be corrected for such that the image formed on the wafer is not distorted once the thermal load of the exposure radiation is removed and the wafer returns to an undistorted state, as now discussed.

Within a scanning lithographic apparatus, at first order, a thermal deformation of a single target region of the wafer (also referred to as a field) may, for example, result in a magnification of the target region which is dependent on position in a scanning direction. For example, at an edge of the target region that is exposed at a start of the scanning exposure, a portion of the target region being exposed may have first dimensions whereas at an edge of the target region that is exposed at an end of the scanning exposure, a portion of the target region being exposed may have second dimensions. The second dimensions may be larger than the first dimensions. Therefore, to first order, the thermal deformation of the wafer caused by exposure to the radiation during the scanning exposure may result in variation in the size of the target region as a function of the scanning direction. A target region or field to be exposed on a wafer may have dimensions of the order of 10-100 mm whereas the magnitude of the thermally induced deformations may be of the order of 2-10 nm.

At first order, such thermally induced deformations could, in principle, be corrected for by adjusting a magnification factor achieved by the imaging system (for example such that as the wafer expands during the scanning exposure so too does the image formed by the imaging system). With a spherical imaging system, such an adjustment of the magnification factor could, in principle, be made by controlling a position of the object (e.g. a reticle) and the wafer relative to the imaging optics dynamically during the scanning exposure.

It is currently proposed to use rigid body movements of optical elements (e.g. mirrors) in the imaging system to partially correct for printing errors that would be caused by the thermal distortion of the wafer during exposure to the radiation. Put differently, the proposed rigid body movements of optical elements in the imaging system may induce optical aberrations that dynamically distort an aerial image formed by the imaging optics during the exposure process such that it matches a (dynamic) thermal distortion of the wafer during the exposure process. Advantageously, with such an arrangement, once the thermal load of the exposure radiation is removed and the wafer returns to an un-distorted state, the image formed on the wafer is not distorted.

Note that these movements may be small with respect to the typical dimensions of the optical elements. For example, the optical elements may have a typical dimension of the order of 0.1 m to 1 m whereas the magnitude of the rigid body movements used for aberration correction may be of the order of 1 $\mu$m.

The method according to the first aspect allows for values of one or more movement parameters of at least one optical element of the imaging system to be determined that may achieve this correction for the thermal distortion of the wafer during exposure. Advantageously, by moving the at least one optical element of the imaging system more complex distortions of the aerial image may be achieved than, for example, merely moving the reticle and the wafer (relative to the imaging optics) during the exposure. In turn, advantageously, this may allow for such corrections to be achieved when the imaging optics are anamorphic. Additionally or alternatively, for imaging systems comprising a plurality of optical elements, movement of a plurality of optical elements may provide more degrees of freedom that can potentially be used for the correction. Advantageously, this may allow for a more accurate correction for the dynamic thermal deformation of the wafer (for example by correcting using higher order aberrations).

The method according to the first aspect involves determining values of one or more movement parameters of at least one optical element of the imaging system in dependence on the determined deformation of the substrate due to the exposure to the radiation. The method according to the first aspect involves determining a deformation of the substrate due to exposure to the radiation. It will be appreciated that this deformation may be determined using one or more models. That is, the deformation may be a predicted deformation, based on such models. Alternatively, the deformation may be measured directly.

The optical system may have m degrees of freedom. Each optical element may have three translational degrees of freedom (x, y and z) and three rotational degrees of freedom (Rx, Ry, Rz). There may be n mirrors that can be moved. Therefore, the optical system may have 6n degrees of freedom. The degrees of freedom of the optical system may be referred to as $D_i$, where i = 1, ... ,m.

In some embodiments, each mirror may be moved in such a way that it has minimal deformations.

The determined value(s) of the one or more movement parameters may be such that a deformation of the or each image during the formation of that image at least partially corrects for a deformation of the substrate due to exposure to the radiation during the formation of that image.

That is, the determined value(s) of the one or more movement parameters may be such that, when the one or more movement parameters are used during the formation of an image, once the substrate has returned to an undistorted state, the image formed on the substrate is less distorted than it would have been if the optical elements had remained static during the exposure.

For example, the determined value(s) of the one or more movement parameters may be such that, when the one or more movement parameters are used during the formation of an image, the aerial image formed is (dynamically) distorted in a manner that substantially matches a (dynamic) distortion of the substrate.

The determined value(s) of the one or more movement parameters may be such that, for at least one optical aberration of the imaging system, a distortion of at least one of the one or more images due to such movement of the at least one optical element at least partially corrects for a deformation of the substrate due to exposure to the radiation during formation of that image.

Optical aberrations describe a departure from perfect imaging performance. Perfect imaging performance may be achieved by spherical wavefronts converging to a point at each point in the image plane. Put differently, perfect optical performance is achieved when the optical path length is the same for all parts of the converging light cone at the image plane. Optical aberrations may be described as a departure of the wavefront from such perfect imaging (e.g. a perfect spherical wavefront). Optical aberrations may be well described by a wavefront (or relative phase) map in a pupil plane of the imaging system. Such a wavefront map may be expressed as a linear combination of Zernike polynomials (which form a complete orthonormal set on a unit circle). Alternatively, such a wavefront map may be expressed as a linear combination of Zernike-Tatian polynomials (also referred to herein as Tatian polynomials).

As used here "an optical aberration of the imaging optics" may mean one or more coefficients in such a Zernike polynomial expansion or a Tatian polynomial expansion.

In some embodiments, the determined value(s) of the one or more movement parameters are such that one or more optical aberrations of the imaging system are optimized.

The determined value(s) of the one or more movement parameters may be such that, for one or more optical aberrations of the imaging system, a difference between: (a) a contribution caused by such movement; and (b) a contribution caused by a deformation of the substrate due to exposure to the radiation is minimized.

It will be appreciated that, minimizing a difference between the two contributions for one or more optical aberrations of the imaging system may use any suitable optimization merit function. For example, in some embodiments, it may be desirable to minimize variation in a map of the difference in the pupil plane. In some embodiments, certain components of optical aberrations (for example certain Zernike components) may have a particularly large effect on imaging performance and so it may be particularly desirable to minimize the difference between the two contributions for these components and the merit function may reflect this.

Furthermore, note that the optimization or minimization may be subject to certain constraints. For example, the optimization or minimization may take into account the capabilities of mechatronics of the optical elements.

It will be appreciated that minimizing a difference between the two contributions for one or more optical aberrations of the imaging system may comprise the use of any optimization method (for example to minimize a merit function) as desired or required. Examples of such optimization methods may include, for example, any of the following: genetic optimization algorithms; Newton's method in optimization (also known as the Newton-Raphson method); simulated annealing; a least squares method; a quadratic programming active set method; an interior-point method; and/or a quadratic constrained quadratic programing method.

The determined value(s) of the one or more movement parameters may be such that, for one or more optical aberrations of the imaging system, a difference between: (a) a contribution caused by such movement; and (b) a contribution caused by a deformation of the substrate due to exposure to the radiation is reduced relative to an exposure in which the optical elements do not move.

The determined deformation of the substrate due to exposure to the radiation may be calculated using a model.

The value of the one or more movement parameters of at least one optical element of the imaging system during the formation of a given image may be determined in dependence on the determined deformation of the substrate due to the exposure to the radiation during the formation of that image.

That is, the movement parameters for a given image are based on an expected deformation of the substrate during the formation of that image.

The value(s) of the one or more movement parameters may be determined for forming an image of an object on a substrate a plurality of times in succession. The value of the one or more movement parameters of at least one optical element of the imaging system during the formation of a given image may be determined in dependence on the determined deformation of the substrate due to the exposure to the radiation during the formation of one or more previous images.

That is, a scanning history of the substrate may be taken into account such that the movement parameters for a given image are based on a deformation of the substrate during the formation of any previous images.

It will be appreciated that a substrate used in a lithographic apparatus (e.g. a resist-coated silicon wafer) typically comprises a plurality of target regions. The same image (as defined by a reticle or mask) may be formed on each of the target regions. There may be, for example, of the order of 100 target regions or more.

The method may use a scanning model to map a scanning trajectory to a deformation of a target region of the substrate on which the or each image is formed.

Such a scanning model may be able to quantify a thermal deformation of the substrate and may take into account the intensity of the radiation and a scanning trajectory and a scanning speed.

The method may use an optical model to map deformation of the substrate to optical aberrations of the imaging system.

For example, for a given expected deformation of the substrate, the optical model may determine a target relative phase map that will ensure that the aerial image is distorted in the same way as the substrate.

The method may use a model to map the one or more movement parameters of each of the at least one optical element to at least one optical aberration of the imaging system.

If a degree of freedom $D_i(t)$ is time-dependent then a time dependence of a wavefront aberration $Z_j$ to this degree of freedom, $Z_{j;i}(t)$, may be of the form of:

$$Z_{j;i}(t;x,y) \;=\; a_{j,i}(x,y) \cdot D_i(t). \tag{1}$$

Note that, in general, the coefficient, $a_{j,i}$, is not merely a scalar but may be a function of position within a field plane ($a_{j,i}(x,y)$). The model may use the coefficients $a_{j,i}(x,y)$ to map the wavefront aberrations $Z_j$ to the degree(s) of freedom $D_i(t)$ and vice versa. For example, a target relative phase map (which may have been determined using the optical model) may be used to determine a time dependence of a set of degrees of freedom $\{D_i(t)\}$.

Note that as used herein when it is stated that the method comprises determining a value of one or more movement parameters of at least one optical element of the imaging system during the formation of the image, said movement parameters may be any parameters that parameterize movement of the at least one optical element. For example, when stated herein that the one or more movement parameters are such that at least one degree of freedom of the at least optical element has a non-zero velocity during at least part of the formation of the image, this is intended to mean at least one parameter that parameterizes movement of the at least one optical element such that it moves. Note that this does not necessarily mean that the velocity is determined directly. For example, this may involve selecting values of any parameters that parameterize one or more degrees of freedom, $D_i(t)$, of the optical system as a function of time during an exposure time period such that during that time period a velocity of said one or more degrees of freedom is non zero (i.e.

$$D_i'(t) \neq 0 \; ).$$

Each degree of freedom of the imaging system may be parameterized as a sum of basis functions or basis splines. Determining one or more movement parameters of an optical element may comprise determining a set of coefficients in the sum of basis functions.

In some embodiments, each degree of freedom $D_i(t)$ may be parameterized as a sum of a basis functions or basis splines (also known as B-splines). For example, a degree of freedom $D_i$ may be parameterized as follows:

$$D_i(t) = \sum_k c_k \cdot b_k(t), \tag{2}$$

where $b_k(t)$ are a set *of* $k$ basis functions or B-splines and $c_k$ are a set of $k$ coefficients. For such embodiments, determining one or more movement parameters of an optical element may comprise determining a set of coefficients $c_k$ in an expansion of the type shown in equation (2) for at least one degree of freedom $D_i$ associated with that optical element. Therefore, for such embodiments the determined movement parameters will, in general, not be velocities, however, the combination of B-spline coefficients $c_k$ will determine the velocity of the optical element over an entire trajectory during formation of the image.

The sum of basis functions or basis splines may be selected so as to ensure continuity of the position and velocity of the or each at least one optical element.

The sum of basis functions or basis splines may be selected so as to ensure continuity of the acceleration of the or each at least one optical element

According to a second aspect of the present disclosure there is provided an exposure method comprising at least one exposure process, the or each exposure process comprising: patterning a radiation beam using a patterning device so as to form patterned radiation; using imaging optics to collect the patterned radiation and to form an image of the patterning device on a substrate; wherein at least one optical element of the imaging optics moves during the formation of the image according to one or more movement parameters determined by the method of the first aspect of the present disclosure.

The method of the second aspect of the present disclosure is advantageous, as it may allow for thermal distortions of the wafer during the exposure to be at least partially cancelled by a matching distortion of the image, resulting in reduced printing errors and optimized imaging performance.

The method according to the second aspect of the present disclosure may further comprise carrying out the method of the first aspect of the present disclosure.

Additionally or alternatively, the method according to the second aspect of the present disclosure may further comprising reading an output of the method of the first aspect of the present disclosure from a storage medium and using this output to control movement of the at least one optical element.

A position of the at least one optical element of the imaging optics may be controlled during the formation of the image according to the one or more determined movement parameters using a feedforward control.

Additionally or alternatively, a position of at least one optical element of the imaging optics may be controlled during the formation of an image using a feedback control.

According to a third aspect of the present disclosure there is provided a lithographic apparatus or a lithographic system comprising: imaging optics; and a controller operable to perform the method of the first and/or second aspects of the present disclosure.

The lithographic apparatus of the third aspect of the present disclosure is advantageous, as it may allow for thermal distortions of the wafer during the exposure to be at least partially cancelled by a matching distortion of the image, resulting in reduced printing errors and optimized imaging performance.

According to a fourth aspect of the present disclosure there is provided a lithographic apparatus or a lithographic system comprising: a first support for supporting a patterning device; a second support for supporting a substrate; and imaging optics operable to form one or more images of a patterning device supported by the first support on a substrate supported by the second support; wherein the imaging optics comprises a plurality of optical elements; and wherein at least one of the plurality of optical elements is movable and is configured to move during the formation of at least one image by the imaging optics.

Since at least one of the plurality of optical elements is configured to move during the formation of at least one image by the imaging optics, advantageously, the lithographic apparatus of the fourth aspect of the present disclosure allows for the image(s) formed by the imaging optics to be dynamically controlled during the formation of said image(s). For example, the size and/or shape of the image(s) may change as the at least one of the plurality of optical elements moves (during the formation of said image(s)). This may allow, for example, for thermal distortions of the substrate (wafer) during the exposure to be at least partially cancelled by a matching distortion of the image, resulting in reduced printing errors and optimized imaging performance.

The lithographic apparatus according to the fourth aspect of the present disclosure may further comprise a controller operable to perform the method of the first and/or second aspects of the present disclosure.

According to a fifth aspect of the present disclosure there is provided a computer comprising: one or more processors; and storage media, the storage media having instructions to cause the one or more processors to carrying out the method of the first and/or second aspects of the present disclosure.

The one or more processors may be configured to store on the storage media one or more movement parameters determined by the method of the first aspect of the present disclosure.

According to a sixth aspect of the present disclosure there is provided a computer-readable medium having instructions for carrying out the method of the first and/or second aspects of the present disclosure.

The computer-readable medium may be a non-transitory computer-readable medium.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 is a schematic illustration of a new method for determining a value of one or more parameters for an imaging system that is for forming an image of an object on a substrate according to an embodiment of the present disclosure;
- Figure 3 is a first schematic representation of a single target region of a wafer, showing both: (a) a shape of the target region when it is not deformed due to the radiation beam (indicated by a dashed line); and (b) a shape of the target region when is deformed due to the radiation beam during a scanning exposure (indicated by a solid line);
- Figure 4 is a second schematic representation of a single target region of a wafer, showing both: (a) a shape of the target region when it is not deformed due to the radiation beam (indicated by a dashed line); and (b) a shape of the target region when is deformed due to the radiation beam during a scanning exposure (indicated by a solid line);
- Figure 5 schematically shows two adjacent target regions of a wafer which are exposed sequentially using two opposite scan directions; these two consecutive exposures may form part of a meander scan, for example a meander scan of the type shown in Figure 6;

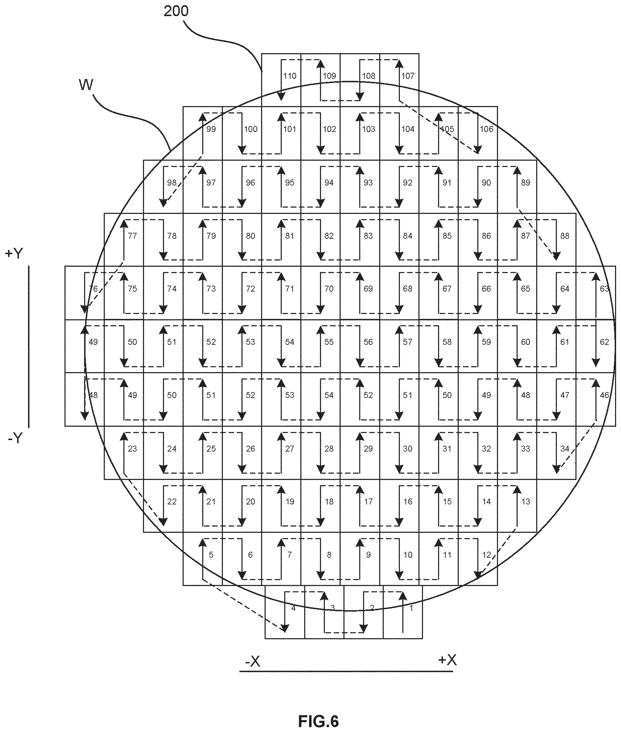

- Figure 6 is a schematic plan view representation of a (generally circular) substrate comprising a plurality of (generally rectangular) target regions or dies; also shown is a standard meander scan pattern in which each row of target regions (extending in a non-scanning direction) is exposed in turn, with the order of the exposure of the target regions indicated by a number on each target region, the scanning direction of the exposure of each target region is indicated by a solid arrow and the movement of the substrate in between exposure of two consecutive target regions is indicated by dashed lines;
- Figure 7 is a schematic illustration of a new exposure method according to an embodiment of the present disclosure; and
- Figure 8 is a schematic representation of an example control loop that may be used during the exposure method shown in Figure 7.

DETAILED DESCRIPTION

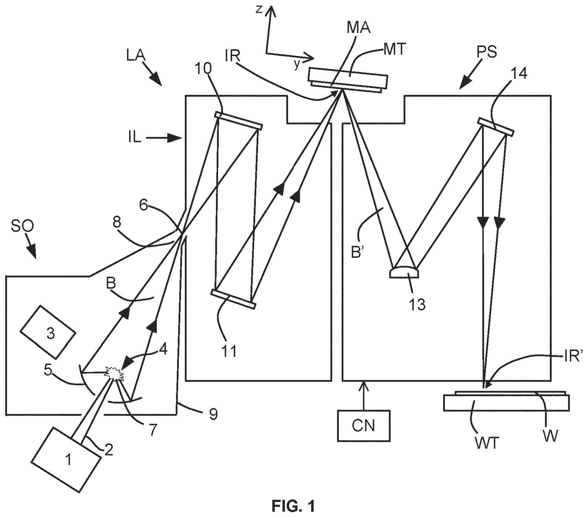

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask or a reticle), a projection system PS and a substrate table WT configured to support a substrate W. The support structure MT may be considered to be a first support for supporting a patterning device MA. The substrate table WT may be considered to be a second support for supporting a substrate W. As used herein the terms "mask" and "reticle" are mutually synonymous and may be used interchangeably.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors). Herein the projection system PS may alternatively be referred to as the imaging system PS.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

The illumination region IR is in a field plane in which the reticle MA is disposed during a lithographic exposure. Therefore, the illumination region IR may be referred as a reticle-level or object-level illumination region IR. It will be appreciated that projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit.

The lithographic apparatus LA may be a scanning lithographic apparatus (also referred to as a scanner) and the image (of a reticle MA) may be formed during a scanning exposure. In such an exposure, the reticle MA may be moved in a scanning direction through the reticle-level illumination region IR. It will be appreciated that, as a result of this movement of the reticle MA, the image of the reticle MA will move at wafer level. Therefore, during the scanning exposure, the wafer W is also moved through the wafer-level illumination region IR'. In particular, the wafer W is moved so that the image of reticle MA is substantially static with respect to the wafer W. The movement of the reticle MA and the substrate W are therefore synchronized. The movement (speed and direction) of the substrate W will be dependent on the movement of the reticle and the imaging performed by the projection system PS. In some embodiments, the projection system PS may form an inverted image of the reticle MA and therefore the substrate W may be moved in an opposite direction to the reticle MA. In some embodiments, the projection system PS may apply a reduction factor to the patterned EUV radiation beam B' in the scanning direction and therefore the substrate W may move at a speed that is smaller than the speed of the reticle MA by this reduction factor.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. It will be appreciated that the obscuration may have any shape or configuration.

Typically, the intensity distribution of the radiation in field planes of a lithographic apparatus has the following general shape in a scanning direction of the lithographic apparatus: there is a central portion which is generally flat and two peripheral portions on either side of the central portion in which the intensity falls to zero. For example, the intensity distribution in the scanning direction may be generally of the shape of a trapezium.

In general, the projection system PS has an optical transfer function which may be nonuniform, which can affect the pattern which is imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be obtained from a measured scalar map by calculating the inner product of the measured scalar map with each Zernike polynomial in turn and dividing this by the square of the norm of that Zernike polynomial. In the following, unless stated otherwise, any reference to Zernike coefficients will be understood to mean the Zernike coefficients of a relative phase map (also referred to herein as an aberration map). It will be appreciated that in alternative embodiments other sets of basis functions may be used. For example, some embodiments may use Zernike-Tatian polynomials, for example for obscured aperture systems.

Optical aberrations describe a departure from perfect imaging performance. Perfect imaging performance may be achieved by spherical wavefronts converging to a point at each point in the image plane. Put differently, perfect optical performance is achieved when the optical path length is the same for all parts of the converging light cone at the image plane. Optical aberrations may be described as a departure of the wavefront from such perfect imaging (e.g. a perfect spherical wavefront). Optical aberrations may be well described by a wavefront (or relative phase) map in a pupil plane of the imaging system.

The wavefront aberration map represents the distortions of the wavefront of light approaching a point in an image plane of the projection system PS from a spherical wavefront (as a function of position in the pupil plane or, alternatively, the angle at which radiation approaches the image plane of the projection system PS). As discussed, this wavefront aberration map $W(x,y)$ may be expressed as a linear combination of Zernike polynomials:

$$W(x, y) = \sum_n Z_n \cdot z_n(x, y), \qquad\qquad (3)$$

where x and y are coordinates in the pupil plane, $z_n(x, y)$ is the nth Zernike polynomial and $Z_n$ is a coefficient. It will be appreciated that in the following, Zernike polynomials and coefficients are labelled with an index, which is commonly referred to as a Noll index. Therefore, $z_n(x, y)$ is the Zernike polynomial having a Noll index of n and $Z_n$ is a coefficient having a Noll index of n. The wavefront aberration map may then be characterized by the set of coefficients Z in such an expansion, which may be referred to as Zernike coefficients. Note that $W(x,y)$ may alternatively be expressed as a linear combination of Zernike-Tatian polynomials (also referred to herein as Tatian polynomials) in a similar way (i.e. a similar expansion to that expressed in equation (3)) and when used below any reference to Zernike coefficients $Z_n$ may alternatively mean similarly defined Zernike-Tatian coefficients (or simply Tatian coefficients).

It will be appreciated that only a finite number of Zernike orders are taken into account. Different Zernike coefficients of the phase map may provide information about different forms of aberration which are caused by the projection system PS. The Zernike coefficient having a Noll index of 1 may be referred to as the first Zernike coefficient, the Zernike coefficient having a Noll index of 2 may be referred to as the second Zernike coefficient and so on.

The first Zernike coefficient, $Z_1$, relates to a mean value (which may be referred to as a piston) of a measured wavefront. The first Zernike coefficient may be irrelevant to the performance of the projection system PS and as such may not be corrected for using the methods described herein. The second Zernike coefficient, $Z_2$, relates to the tilt of a measured wavefront in the x-direction. The tilt of a wavefront in the x-direction is equivalent to a placement in the x-direction. The third Zernike coefficient, $Z_3$, relates to the tilt of a measured wavefront in the y-direction. The tilt of a wavefront in the y-direction is equivalent to a placement in the y-direction. The fourth Zernike coefficient, $Z_4$, relates to a defocus of a measured wavefront. The fourth Zernike coefficient is equivalent to a placement in the z-direction. Higher order Zernike coefficients relate to other forms of aberration which are caused by the projection system (e.g. astigmatism, coma, spherical aberrations and other effects).

Throughout this description the term "aberrations" should be intended to include all forms of deviation of a wavefront from a perfect spherical wavefront. That is, the term "aberrations" may relate to the placement of an image (e.g. the second, third and fourth Zernike coefficients) and/or to higher order aberrations such as those which relate to Zernike coefficients having a Noll index of 5 or more. Furthermore, any reference to an aberration map for a projection system PS may include all forms of deviation of a wavefront from a perfect spherical wavefront, including those due to image placement.

The transmission map and the relative phase map are field and system dependent. That is, in general, each projection system PS will have a different Zernike expansion for each field point (i.e. for each spatial location in its image plane).

As will be known to the skilled person, the relative phase of the projection system PS in its pupil plane may be determined by projecting radiation from an object plane of the projection system PS (i.e. the plane of the patterning device MA), through the projection system PS and using a shearing interferometer to measure a wavefront (i.e. a locus of points with the same phase). The shearing interferometer may comprise a diffraction grating, for example a two dimensional diffraction grating, in an image plane of the projection system (i.e. the substrate table WT) and a detector arranged to detect an interference pattern in a plane that is conjugate to a pupil plane of the projection system PS.

Some embodiments of the present disclosure relate to new methods for determining a value of one or more parameters for an imaging system that is for forming an image of an object on a substrate. The method may have particular application to an imaging system of a lithographic apparatus. The imaging system may be a projection system PS of a lithographic apparatus LA of the type shown schematically in Figure 1 and described above. The object may be a reticle or patterning device MA and the substrate may be a resist-coated silicon wafer W.

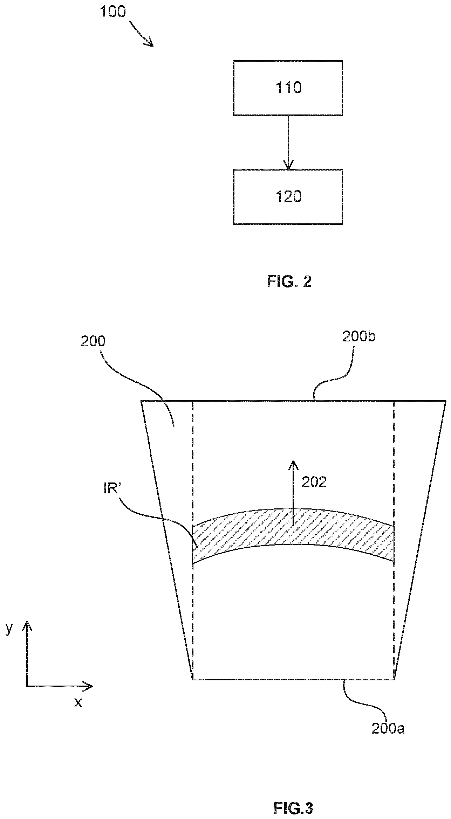

An example of a new method 100 according to the present disclosure is shown schematically in Figure 2. The method 100 is for determining a value of one or more movement parameters for an imaging system PS that is for forming one or more images of an object MA on a substrate W using radiation B'.

The method 100 comprises a step 110 of determining a deformation of the substrate W due to exposure to the radiation B'.

The method 100 further comprises a step 120 of determining a value of one or more movement parameters of at least one optical element of the imaging system PS during the formation of one of the one or more images. The value of the one or more movement parameters is determined in dependence on the determined deformation of the substrate W due to the exposure to the radiation B'.

The method 100 shown in Figure 2 is advantageous, as now discussed. The method 100 may have particular application to an imaging system PS of a lithographic apparatus LA. The lithographic apparatus LA may be a scanning lithographic apparatus LA (also referred to as a scanner) and the image(s) (of a reticle MA) may be formed during a scanning exposure. In such an exposure, the wafer W may be moved in a scanning direction through a wafer-level illumination region IR' (also referred to as an illumination slit or slit).

Within a lithographic apparatus, the radiation beam B' used to expose the wafer W may cause (time-dependent) thermal deformation of the wafer W. In turn, this can cause a mismatch between a shape of the wafer and the image formed by the projection system PS, resulting in printing errors and degrading optical performance. Advantageously, the method 100 shown schematically in Figure 2 allows for such thermal deformation of the wafer W to be corrected for such that the image formed on the wafer W is not distorted once the thermal load of the exposure radiation B' is removed and the wafer returns to an un-distorted state, as now discussed.

Figure 3 shows schematically a single target region 200 of a wafer W. A shape of the target region 200 when it is not deformed due to the radiation beam B' is indicated as a dashed line and is generally rectangular. Also shown in Figure 3 is the wafer-level illumination region IR' and a direction in which the wafer-level illumination region IR' effectively scans over the target region 200 is indicated by arrow 202. It will be appreciated that, in practice this may be achieved by scanning the target region 200 through the wafer-level illumination region IR' in a direction opposite to the arrow 202. A shape of the target region 200 when it is deformed due to the radiation beam B' during a scanning exposure is indicated as a solid line.

As indicated schematically in Figure 3, within such a scanning lithographic apparatus LA, at first order, a thermal deformation of a single target region 200 of the wafer W (also referred to as a field) may, for example, result in a magnification of the target region 200 which is dependent on position in a scanning direction (the y-direction in Figure 3). For example, at an edge 200a of the target region 200 that is exposed at a start of the scanning exposure, a portion of the target region 200 being exposed may have first dimensions whereas at an edge 200b of the target region that is exposed at an end of the scanning exposure, a portion of the target region 200 being exposed may have second dimensions. The second dimensions may be larger than the first dimensions. Therefore, to first order, the thermal deformation of the wafer W caused by exposure to the radiation during the scanning exposure may result in variation in the size of the target region 200 as a function of the scanning direction (y-direction).

It will be appreciated that Figure 3 is schematic and that it does not show the exact shape of the deformed target region 200. It will also be appreciated that the scale of the distortion has been exaggerated in Figure 3. A target region 200 or field to be exposed on a wafer W may have dimensions of the order of 10-100 mm whereas the magnitude of the thermally induced deformations may be of the order of 2-10 nm.

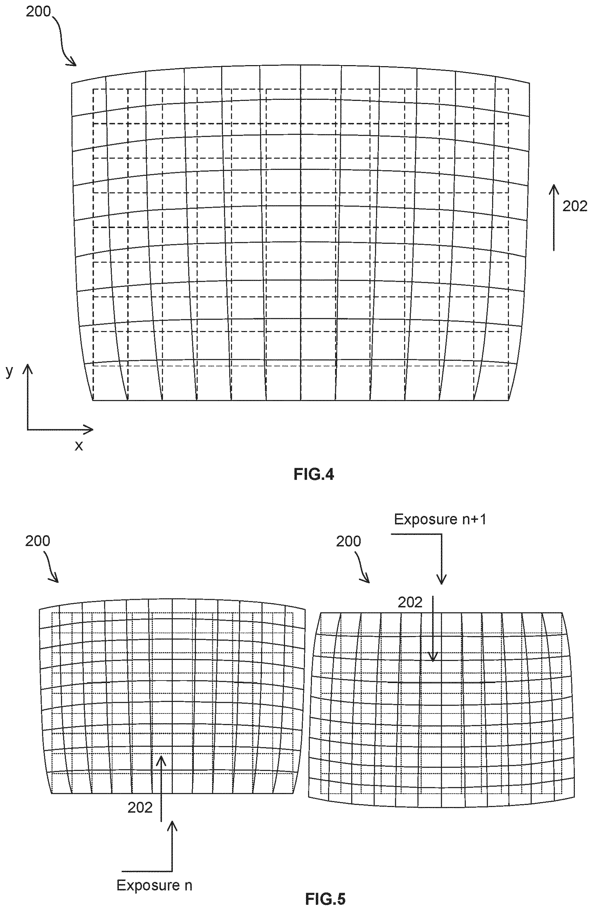

Figure 4 shows schematically an alternative representation of a single target region 200 of a wafer W. A shape of the target region 200 when it is not deformed due to the radiation beam B' is indicated as a dashed line and is generally rectangular. A shape of the target region 200 when is deformed due to the radiation beam B' during a scanning exposure is indicated as a solid line. As in Figure 3, in Figure 4 a direction in which the wafer-level illumination region IR' effectively scans over the target region 200 is indicated by arrow 202. It will be appreciated that, in practice this may be achieved by scanning the target region 200 through the wafer-level illumination region IR' in a direction opposite to the arrow 202.

At first order, such thermally induced deformations could, in principle, be corrected for by adjusting a magnification factor achieved by the imaging system PS (for example such that as the wafer W expands during the scanning exposure so too does the image formed by the imaging system PS). With a spherical imaging system, such an adjustment of the magnification factor could, in principle, be made by controlling a position of the object (e.g. a reticle MA) and the wafer W relative to the imaging optics PS dynamically during the scanning exposure (for example by moving the support structure MT and/or the substrate table WT).

It is currently proposed to use rigid body movements of optical elements (e.g. mirrors) in the imaging system PS to at least partially correct for printing errors that would be caused by the thermal distortion of the wafer W during exposure to the radiation B'. Put differently, the proposed rigid body movements of optical elements in the imaging system PS may induce optical aberrations that dynamically distort an aerial image formed by the imaging optics PS during the exposure process such that it matches a (dynamic) thermal distortion of the wafer W during the exposure process. Advantageously, with such an arrangement, once the thermal load of the exposure radiation B' is removed and the wafer W returns to an un-distorted state (e.g. as indicate by the dashed line in Figure 3), the image formed on the wafer W is not distorted.

These rigid body movements are made in accordance with the value(s) of the one or more movement parameters of at least one optical element of the imaging system PS determined at step 120.

Note that these movements may be small with respect to the typical dimensions of the optical elements. For example, the optical elements may have a typical dimension of the order of 0.1 m to 1 m whereas the magnitude of the rigid body movements used for aberration correction may be of the order of 1 $\mu$m.

The method 100 shown schematically in Figure 2 allows for values of one or more movement parameters of at least one optical element of the imaging system to be determined that may achieve this correction for the thermal distortion of the wafer W during exposure. Advantageously, by moving the at least one optical element of the imaging system more complex distortions of the aerial image may be achieved than, for example, merely moving the reticle MA and the wafer W (relative to the imaging optics PS) during the exposure. In turn, advantageously, this may allow for such corrections to be achieved when the imaging optics PS are anamorphic. Additionally or alternatively, for imaging systems PS comprising a plurality of optical elements, movement of a plurality of optical elements may provide more degrees of freedom that can potentially be used for the correction. Advantageously, this may allow for a more accurate correction for the dynamic thermal deformation of the wafer (for example by correcting using higher order aberrations).

The method 100 involves (at step 120) determining values of one or more movement parameters of at least one optical element of the imaging system PS in dependence on the determined deformation of the substrate W due to the exposure to the radiation B'. The method 100 involves (at step 110) determining a deformation of the substrate W due to exposure to the radiation B'. It will be appreciated that this deformation may be determined using one or more models. That is, the deformation may be a predicted deformation, based on such models. Alternatively, the deformation may be measured directly.

In some embodiments, each mirror may be moved in such a way that it has minimal deformations.

The optical system PS may have m degrees of freedom. Each optical element may have three translational degrees of freedom (x, y and z) and three rotational degrees of freedom (Rx, Ry and Rz). There may be n mirrors that can be moved. Therefore, the optical system may have upto 6n degrees of freedom. In addition, the support structure MT is movable so that the patterning device MA can be moved and the substrate table WT is movable so that the substrate W can be moved. In particular, each of the patterning device MA and the substrate W can be moved in three translational degrees of freedom (x, y and z) and three rotational degrees of freedom (Rx, Ry and Rz). Therefore, in principle, if there are n mirrors that can be moved then the system has $6 \cdot (n + 2)$ movable elements. However, note that, although each of the patterning device MA and the substrate W can be moved independently in 6 degrees of freedom it is the relative position of the patterning device MA and the substrate W which can affect the image formed on the substrate W. Therefore, if there are n mirrors that can be moved then the system has $6 \cdot (n + 1)$ movable elements that can affect the image formed on the substrate W.

The degrees of freedom of the optical system may be referred to as $D_i$, where $i = 1, \ldots, m$. It will be appreciated that the method 100 comprises determining a value of one or more movement parameters of at least one optical element of the imaging system PS during the formation of the image and that this means that, in general, at least one degree of freedom, $D_i(t)$, of the optical system will be actuated (e.g. continuously) during the exposure process, leading to non-zero velocities of at least some of the optical elements. In general, each degree of freedom may be parameterized by a plurality of parameters. Therefore, more than 6n parameters may be selected. For example, if degree of freedom $D_i$ is parameterized as a function of time by $p_i$ parameters then, in total, there will be $\sum_{i=1}^{6n} p_i$ parameters, values of which may be determined using the method 100.

As used herein $D_i'(t)$ is intended to mean the first differential of $D_i$ with respect to time, i.e. $D_i'(t) = dD_i/dt$ and $D_i''(t)$ is intended to mean the second differential of $D_i$ with respect to time, i.e. $D_i''(t) = d^2D_i/dt^2$.

Note that as used herein when it is stated that the method comprises determining a value of one or more movement parameters of at least one optical element of the imaging system PS during the formation of the image, said movement parameters may be any parameters that parameterize movement of the at least one optical element. For example, this may involve selecting values of any parameters that parameterize one or more degrees of freedom, $D_i(t)$, of the optical system as a function of time during an exposure time period such that during that time period a velocity $D_i'(t)$ of said one or more degrees of freedom is non zero (i.e. $D_i'(t) \neq 0$).

In some embodiments, each degree of freedom $D_i(t)$ may be parameterized as a sum of a basis functions or basis splines (also known as B-splines). For example, a degree of freedom $D_i$ may be parameterized as follows:

$$D_i(t) = \sum_k c_k \cdot b_k(t) \qquad (4)$$

where $b_k(t)$ are a set of k basis functions or B-splines and $c_k$ are a set of k coefficients. For such embodiments, determining one or more movement parameters of an optical element may comprise determining a set of coefficients $c_k$ in an expansion of the type shown in equation (4) for at least one degree of freedom $D_i$ associated with that optical element. Therefore, for such embodiments the combination of B-spline coefficients $c_k$ will determine the movement of the optical element over an entire trajectory during formation of the image.

In some embodiments of the method 100 shown in Figure 2, the sum of basis functions or basis splines may be selected so as to ensure continuity of the position and velocity of the or each at least one optical element.

As described above, in some embodiments the determined value(s) of the one or more movement parameters (as determined at step 120) may be such that a deformation of the or each image during the formation of that image at least partially corrects for a deformation of the substrate W due to exposure to the radiation B' during the formation of that image.

That is, the determined value(s) of the one or more movement parameters may be such that, when the one or more movement parameters are used during the formation of an image, once the substrate W has returned to an undistorted state, the image formed on the substrate W is less distorted than it would have been if the optical elements had remained static during the exposure.

For example, the determined value(s) of the one or more movement parameters may be such that, when the one or more movement parameters are used during the formation of an image, the aerial image formed is (dynamically) distorted in a manner that substantially matches a (dynamic) distortion of the substrate W. For example, a thermal deformation of the wafer W caused by exposure to the radiation B' during the formation of one or more images (as determined at step 110) may correspond to a (time-dependent) thermal deformation wavefront map $W_{TD}(x, y; t)$. In the method 100, the determination of value of the one or more movement parameters (at step 120) may be made so as to result in a deformation of the aerial image due to the movement $W_M(x, y; t)$ such that:

$$W_{TD}(x, y; t) = W_M(x, y; t). \qquad (5)$$

In some embodiments of the method 100 shown in Figure 2, the determined value(s) of the one or more movement parameters may be such that a distortion of at least one of the one or more images due to such movement of the at least one optical element at least partially corrects for deformation of the substrate due to exposure to the radiation during formation of that image.

Optical aberrations describe a departure from perfect imaging performance. Perfect imaging performance may be achieved by spherical wavefronts converging to a point at each point in the image plane. Put differently, perfect optical performance is achieved when the optical path length is the same for all parts of the converging light cone at the image plane IR'. Optical aberrations may be described as a departure of the wavefront from such perfect imaging (e.g. a perfect spherical wavefront). Optical aberrations may be well described by a wavefront (or relative phase) map in a pupil plane of the imaging system. Such a wavefront map may be expressed as a linear combination of Zernike polynomials (which form a complete orthonormal set on a unit circle), as described above with reference to equation (3). Alternatively, such a wavefront map may be expressed as a linear combination of Zernike-Tatian polynomials (also referred to herein as Tatian polynomials).

As used here "an optical aberration of the imaging optics" may mean one or more coefficients in such a Zernike polynomial expansion or a Tatian polynomial expansion.

In some embodiments, the determined value(s) of the one or more movement parameters are such that one or more optical aberrations of the imaging system are optimized.

In some embodiments of the method 100 shown in Figure 2, the determined value(s) of the one or more movement parameters may be such that, for one or more optical aberrations $Z_j$ of the imaging system PS, a difference between: (a) a contribution caused by such movement; and (b) a contribution caused by a deformation of the substrate W due to exposure to the radiation is minimized.

It will be appreciated that, minimizing a difference between the two contributions for one or more optical aberrations of the imaging system PS may use any suitable optimization merit function. For example, in some embodiments, it may be desirable to minimize variation in a map of the difference in the pupil plane. In some embodiments, certain components of optical aberrations (for example certain Zernike components) may have a particularly large effect on imaging performance and so it may be particularly desirable to minimize the difference between the two contributions for these components and the merit function may reflect this.

Furthermore, note that the optimization or minimization may be subject to certain constraints. For example, the optimization or minimization may take into account the capabilities of mechatronics of the optical elements.

It will be appreciated that minimizing a difference between the two contributions for one or more optical aberrations $Z_j$ of the imaging system may comprise the use of any optimization method (for example to minimize a merit function) as desired or required. Examples of such optimization methods may include, for example, any of the following: genetic optimization algorithms; Newton's method in optimization (also known as the Newton-Raphson method); simulated annealing; a least squares method; a quadratic programming active set method; an interior-point method; and/or a quadratic constrained quadratic programing method.

In some embodiments of the method 100 shown in Figure 2, the determined value(s) of the one or more movement parameters may be such that, for one or more optical aberrations $Z_j$ of the imaging system PS, a difference between: (a) a contribution caused by such movement; and (b) a contribution caused by a deformation of the substrate W due to exposure to the radiation B' is reduced relative to an exposure in which the optical elements do not move.

In some embodiments of the method 100 shown in Figure 2, the determined deformation of the substrate due to exposure to the radiation may be calculated using a model.

In some embodiments of the method 100 shown in Figure 2, the value of the one or more movement parameters of at least one optical element of the imaging system PS during the formation of a given image may be determined in dependence on the determined deformation of the substrate due to the exposure to the radiation during the formation of that image.

That is, the movement parameters for a given image are based on an expected deformation of the substrate W during the formation of that image (which deformation is shown schematically in Figures 3 and 4).

In some embodiments of the method 100 shown in Figure 2, the value(s) of the one or more movement parameters may be determined for forming an image of an object MA on a substrate W a plurality of times in succession and wherein the value of the one or more movement parameters of at least one optical element of the imaging system PS during the formation of a given image is determined in dependence on the determined deformation of the substrate due to the exposure to the radiation during the formation of one or more previous images.

That is, in such embodiments, a scanning history of the substrate is taken into account such that the movement parameters for a given image are based on a deformation of the substrate W during the formation of any previous images.

It will be appreciated that a substrate W used in a lithographic apparatus (e.g. a resist-coated silicon wafer W) typically comprises a plurality of target regions 200. The same image (as defined by a reticle or mask MA) may be formed on each of the target regions 200. There may be, for example, of the order of 100 target regions 200 or more.

As shown in Figure 5, in some embodiments two adjacent target regions 200 may be exposed sequentially, as an $n$th exposure and an ($n$ + 1)th exposure. The wafer W may be moved such that a direction in which the wafer-level illumination region IR' effectively scans over the target region 200 (indicated by arrows 202) is in a first direction for the nth exposure and in an opposite direction for the ($n$ + 1)th exposure. The value(s) of the one or more movement parameters of at least one optical element of the imaging system PS during the formation of the ($n$ + 1)th image may be determined in dependence on the determined deformation of the substrate W due to the exposure to the radiation during the formation the nth image (and, optionally, one or more additional previously formed images). Note that for such embodiments, the value(s) of the one or more movement parameters of at least one optical element of the imaging system PS during the formation of the ($n$ + 1)th image are also determined in dependence on the determined deformation of the substrate W due to the exposure to the radiation during the formation the ($n$ + 1)th image.

The arrangement shown in Figure 5 may form part of a meander scan, which is now described with reference to Figure 6.

Figure 6 is a schematic plan view representation of a (generally circular) substrate W comprising a plurality of (generally rectangular) target regions 200 or dies. In the embodiment shown in Figure 15 the substrate W comprises 110 target regions 200.

Forming an image of a reticle MA on a substrate a plurality of times may comprise forming an image of the reticle MA on a plurality of target regions 200 of the substrate W. Each of the plurality of target regions 200 may be generally rectangular. The plurality of target regions 200 may be arranged as a two-dimensional array.

In some embodiments, the two-dimensional array of target regions 200 may be exposed using a standard meander scan pattern in which each row of target regions 200 (extending in a non-scanning direction; the x-direction in Figure 6) is exposed in turn. Such a standard meander scan pattern is illustrated in Figure 6, with the order of the exposure of the target regions 200 indicated by a number on each target region. The scanning direction 202 of the exposure of each target region 200 is indicated by a solid arrow and the movement of the substrate W in between exposure of two consecutive target regions 200 is indicated by dashed lines.

In some embodiments of the method 100 shown in Figure 2, the method 100 may use a scanning model to map a scanning trajectory to a deformation of a target region 200 of the substrate W on which the or each image is formed. Such a scanning model may be able to quantify a thermal deformation of the substrate W and may take into account the intensity of the radiation Bi and a scanning trajectory and a scanning speed.

In some embodiments of the method 100 shown in Figure 2, the method 100 may use an optical model to map deformation of the substrate W on to optical aberrations of the imaging system PS. For example, for a given expected deformation of the substrate W, the optical model may determine a (time-dependent) thermal deformation wavefront map $W_{TD}(x, y; t)$. Furthermore, for a given expected deformation of the substrate W, the optical model may determine a target relative phase map $W_M(x, y; t)$ that will ensure that the aerial image is distorted in the same way as the substrate W.

In some embodiments of the method 100 shown in Figure 2, the method 100 may use a model to map the one or more movement parameters of each of the at least one optical element to at least one optical aberration $Z_j$ of the imaging system PS.

If a degree of freedom $D_i(t)$ is time-dependent then a time dependence of a wavefront aberration $Z_j$ to this degree of freedom, $Z_{j;i}(t)$, will be of the form of:

$$Z_{j;i}(t;x,y) \;=\; a_{j,i}(x,y) \cdot D_i(t). \qquad\qquad (6)$$

Note that, in general, the coefficient, $a_{j,i}$, is not merely a scalar but may be a function of position within a field plane ($a_{j,i}(x,y)$). The model may use the coefficients $a_{j,i}(x,y)$ to map the wavefront aberrations $Z_j$ to the degree(s) of freedom $D_i(t)$ and vice versa. For example, a target relative phase map, $W_M(x,y;t)$, (which may have been determined using the optical model) may be used to determine a time dependence of a set of degrees of freedom $\{D_i(t)\}$.

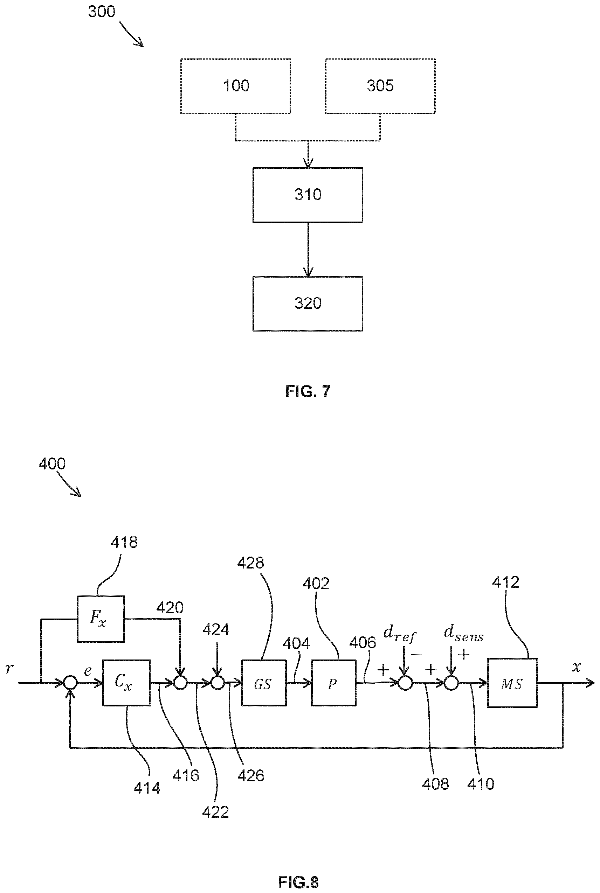

Some embodiments of the present disclosure relate to a new exposure method wherein at least one optical element of the imaging optics moves during the formation of an image according to a value of one or more movement parameters determined by the new method 100 described above. An example of such an exposure method 300 is shown schematically in Figure 7.

The new exposure method 300 comprises a step 310 of patterning a radiation beam using a patterning device MA so as to form patterned radiation.

The new exposure method 300 comprises a step 320 of using imaging optics to collect the patterned radiation B' and to form an image of the patterning device MA on a substrate W. At least one optical element of the imaging optics PS moves during the formation of the image (at step 320) according to one or more movement parameters determined by the method 100 shown in Figure 2.

The new exposure method 300 shown in Figure 7 is advantageous as it may allow for thermal distortions of the wafer W during the exposure to be at least partially cancelled by a matching distortion of the image, resulting in reduced printing errors and optimized imaging performance.

In some embodiments, optionally, the exposure method 300 may comprise a step of carrying out the new method 100 described above.

Additionally or alternatively, the exposure method 300 may comprise step 305 of reading an output of the new method 100 described above from a storage medium and using this output to control movement of the at least one optical element.

In some embodiments of the new exposure method 300 a position of the at least one optical element of the imaging optics PS may be controlled during the formation of the image according to the one or more determined movement parameters using a feedforward control.

In some embodiments of the new exposure method 300 a position of at least one optical element of the imaging optics PS may be controlled during the formation of an image using a feedback control.

Figure 8 is a schematic representation of an example control loop 400 that may be used during the exposure method 300 shown in Figure 7. Each degree of freedom, $D_i$, of the imaging system PS may be controlled according to a control loop 400 of the type shown in Figure 8.

A plant 402 of the control loop 400 receives an input signal 404 and a produces an output signal 406. For example, the plant 402 may comprise one or more degrees of freedom, $D_i$, of one or more optical elements of the imaging system PS. The input signal 404 may comprise one or more signals (for example one or more electrical currents) that are supplied to one or more actuators of the optical element(s). The output signal 406 may comprise one or more signals output by one or more positions sensors or detectors and indicative of a position of an optical element of the imaging system PS. For example, such position sensors may comprise interferometric position sensors.

The output signal 406 may be indicative of an absolute position of one or more optical elements. In practice, the position of one or more optical elements will be measured relative to a reference object (for example a support frame of the imaging system PS). This is indicated in Figure 8 as a reference signal, $d_{ref}$, which may be subtracted from the output signal 406 (indicative of absolute position) to generate a position signal 408 that is relative to the reference object.

The output signal 408 may be subject to measurement or sensor noise, $d_{sens}$, which may be added to the output signal (or, as shown in Figure 8, the position signal 408) to produce a noise-influenced position signal 410. This noise-influenced position signal 410 is the realistic position as measured.

The noise-influenced position signal 410 may be transformed into a degree of freedom signal x by a measurement decoupling unit 412. The measurement decoupling unit 412 may transform positions as measured by various position sensors disposed on an optical element into another co-ordinate space in which the control is performed, as now discussed.

As discussed above, each optical element of the optical system PS comprise 6 degrees of freedom, which may comprise three translational degrees of freedom (x, y and z) and three rotational degrees of freedom (Rx, Ry and Rz). As used herein, unless stated otherwise, the x, y and z directions form a right-handed set of Cartesian axes such that the z-direction is generally aligned with an optical axis of the imaging system PS. The y-direction may be generally aligned with a scanning direction of a lithographic apparatus LA comprising the imaging system PS and the x-direction may be generally aligned with a non-scanning direction of a lithographic apparatus LA. It will be appreciated that these axes are rotated at each optical element (for example as the radiation B' is reflected at each mirror and the optical axis changes).

Therefore, at least six independent position measurements (part of output signal 406) may be made using six position sensors disposed on each optical element. However, in general, each such position measurement will not correspond directly to one of the degrees of freedom, $D_i$, of that optical element (i.e. a position in x, y or z or an orientation about any of the x, y and z axes). Rather, in general, each such position measurement (part of output signal 406) may be a linear combination of these six degrees of freedom, $D_i$, of that optical element. The measurement decoupling unit 412 may transform positions as measured by various position sensors disposed on an optical element into these six degrees of freedom, $D_i$, of that optical element.

A difference between the degree of freedom signal, *x*, and a set point value, r, is determined to form an error signal, *e*. The error signal, *e*, is input into a feedback controller 414, which outputs a feedback signal 416. The feedback signal 416 corrects for any difference between the degree of freedom signal, x, and the set point value, *r*.

A feedforward controller 418 is operable to output a feedforward signal 420. The feedforward signal 420 implements the movement of the at least one optical element of the imaging optics during the formation of the image according to one or more movement parameters determined by the method 100 shown in Figure 2.

The feedback signal 416 and the feed forward signal 420 are summed to form a control loop signal 422.

Optionally, one or more additional signals 424 may be added to the control loop signal to generate a total control loop signal 426.

The total control loop signal 426 may be transformed into the input signal 404 by an actuator decoupling unit 428. The actuator decoupling unit 428 may transform control signals for degrees of freedom, $D_i$, of an optical element in a co-ordinate space in which the control is performed into appropriate control signals (which form part of the input signal 404) for the actuators of that optical element, as now discussed.

Therefore, at least six independent actuators (controlled by the input signal 404) may be used for each optical element. However, in general, each such actuator will not correspond directly to one of the degrees of freedom, $D_i$, of that optical element (i.e. a position in x, y or z or an orientation about any of the x, y and z axes). Rather, in general, each such actuator may actuate a linear combination of these six degrees of freedom, $D_i$, of that optical element. The actuator decoupling unit 428 may transform actuator signals (which form part of the total control loop signal 426) for these six degrees of freedom, $D_i$, of each optical element into appropriate control signals (which form part of the input signal 404) for the actuators of that optical element.

Some embodiments of the present disclosure relate to a lithographic apparatus or a lithographic system, which may be generally of the form shown in Figure 1. In general, the lithographic apparatus LA comprises: imaging optics PS; and a controller CN operable to perform the new methods 100, 300 described above.

The time dependence, $Z_{j;i}(t)$, of a wavefront aberration $Z_j$ to a degree of freedom $D_i$ will be of the form given in equation (6).

Some embodiments of the present disclosure relate to a computer comprising: one or more processors; and storage media, the storage media having instructions to cause the one or more processors to carrying out the new methods 100, 300 described above. In some embodiments, the one or more processors may be configured to store on the storage media value(s) of one or more movement parameters determined by the new method 100 described above.

Some embodiments of the present disclosure relate to a computer-readable medium having instructions for carrying out the methods 100, 300 described above. The computer-readable medium may be a non-transitory computer-readable medium.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the present disclosure in the context of a lithographic apparatus, embodiments of the present disclosure may be used in other apparatus. Embodiments of the present disclosure may form part of a mask inspection apparatus (alternatively referred to as a reticle inspection apparatus), a metrology apparatus, or any apparatus that measures or processes an object such as a wafer (or other substrate) or mask/reticle (or other patterning device). These apparatus may be generally referred to as lithographic tools. Such a lithographic tool may use vacuum conditions or ambient (non-vacuum) conditions.

Although specific reference may be made in this text to embodiments of the present disclosure in the context of EUV lithography, embodiments of the present disclosure may be used in other lithographic apparatus. Such other lithographic apparatus may use exposure radiation having any wavelength. For example, some such other lithographic apparatus may use deep ultraviolet (DUV) exposure radiation.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.  A method for determining a value of one or more movement parameters for an imaging system that is for forming one or more images of an object on a substrate using radiation, the method comprising:

    determining a deformation of the substrate due to exposure to the radiation; and
    determining a value of one or more movement parameters of at least one optical element of the imaging system during the formation of one of the one or more images, the value of the one or more movement parameters being determined in dependence on the determined deformation of the substrate due to the exposure to the radiation.

2.  The method of claim 1 wherein the determined value(s) of the one or more movement parameters is/are such that a deformation of the or each image during the formation of that image at least partially corrects for a deformation of the substrate due to exposure to the radiation during the formation of that image.

3.  The method of claim 1 or claim 2 wherein the determined value(s) of the one or more movement parameters is/are such that, for at least one optical aberration of the imaging system, a distortion of at least one of the one or more images due to such movement of the at least one optical element at least partially corrects for a deformation of the substrate due to exposure to the radiation during formation of that image.

4.  The method of any preceding claim wherein the determined value(s) of the one or more movement parameters is/are such that, for one or more optical aberrations of the imaging system, a difference between: (a) a contribution caused by such movement; and (b) a contribution caused by a deformation of the substrate due to exposure to the radiation is minimized.

5.  The method of any preceding claim wherein the determined value(s) of the one or more movement parameters is/are such that, for one or more optical aberrations of the imaging system, a difference between: (a) a contribution caused by such movement; and (b) a contribution caused by a deformation of the substrate due to exposure to the radiation is reduced relative to an exposure in which the optical elements do not move.

6.  The method of any preceding claim wherein the determined deformation of the substrate due to exposure to the radiation is calculated using a model.

7.  The method of any preceding claim wherein the value of the one or more movement parameters of at least one optical element of the imaging system during the formation of a given image is determined in dependence on the determined deformation of the substrate due to the exposure to the radiation during the formation of that image.

8.  The method of any preceding claim wherein the value(s) of the one or more movement parameters is/are determined for forming an image of an object on a substrate a plurality of times in succession and wherein the value of the one or more movement parameters of at least one optical element of the imaging system during the formation of a given image is determined in dependence on the determined deformation of the substrate due to the exposure to the radiation during the formation of one or more previous images.

9.  The method of any preceding claim wherein the method uses a scanning model to map a scanning trajectory to a deformation of a target region of the substrate on which the or each image is formed.

10. The method of any preceding claim wherein the method uses an optical model to map deformation of the substrate to optical aberrations of the imaging system.

11. The method of any preceding claim wherein the method uses a model to map the one or more movement parameters of each of the at least one optical element to at least one optical aberration of the imaging system.

12. The method of any preceding claim wherein each degree of freedom of the imaging system is parameterized as a sum of a basis functions or basis splines and wherein determining one or more movement parameters of an optical element comprises determining a set of coefficients in the sum of a basis functions.

13. The method of claim 12 wherein the sum of basis functions or basis splines is selected so as to ensure continuity of the position and velocity of the or each at least one optical element.

14. An exposure method comprising at least one exposure process, the or each exposure process comprising:

patterning a radiation beam using a patterning device so as to form patterned radiation;
using imaging optics to collect the patterned radiation and to form an image of the patterning device on a substrate;
wherein at least one optical element of the imaging optics moves during the formation of the image according to one or more movement parameters determined by the method of any preceding claim.

15. The method of claim 14 further comprising carrying out the method of any one of claims 1 to 13.

16. The method of claim 14 or claim 15 further comprising reading an output of the method of any one of claims 1 to 13 from a storage medium and using this output to control movement of the at least one optical element.

17. The method of any one of claims 14 to 16 wherein a position of the at least one optical element of the imaging optics is controlled during the formation of the image according to the one or more determined movement parameters using a feedforward control.

18. The method of any one of claims 14 to 16 wherein a position of at least one optical element of the imaging optics is controlled during the formation of an image using a feedback control.

19. A lithographic apparatus or a lithographic system comprising:

imaging optics; and
a controller operable to perform the method according to any preceding claim.

20. A lithographic apparatus or a lithographic system comprising:

a first support for supporting a patterning device;
a second support for supporting a substrate; and
imaging optics operable to form one or more images of a patterning device supported by the first support on a substrate supported by the second support;
wherein the imaging optics comprises a plurality of optical elements; and
wherein at least one of the plurality of optical elements is movable and is configured to move during the formation of at least one image by the imaging optics.

21. The lithographic apparatus of claim 20 further comprising a controller operable to perform the method according to any one of claims 1 to 18.

22. A computer comprising:

one or more processors; and
storage media, the storage media having instructions to cause the one or more processors to carrying out the method of any one of claims 1 to 18.

23. The computer of claim 22 wherein the one or more processors are configured to store on the storage media one or more movement parameters determined by the method of any one of claims 1 to 13.

24. A computer-readable medium having instructions for carrying out the method of any one of claims 1 to 18.

FIG. 1

100

110

120

**FIG. 2**

200    200b

IR'

202

y

x

200a

**FIG.3**

200

202

y

x

FIG.4

200

Exposure n+1

200

202

202

Exposure n

FIG.5

FIG.6

**FIG. 7**

**FIG.8**

## EUROPEAN SEARCH REPORT

Application Number

EP 24 17 6931

### DOCUMENTS CONSIDERED TO BE RELEVANT

| Category | Citation of document with indication, where appropriate, of relevant passages | Relevant to claim |
|---|---|---|
| X | US 2011/216294 A1 (MENCHTCHIKOV BORIS [NL] ET AL) 8 September 2011 (2011-09-08) * abstract * * figures 1-7 * * paragraphs [0003], [0008], [0011], [0033], [0057] - [0075] * | 1-24 |
| A | JP 2017 215482 A (CANON KK) 7 December 2017 (2017-12-07) * the whole document * | 1-24 |

**CLASSIFICATION OF THE APPLICATION (IPC)**

INV.
G03F7/00

**TECHNICAL FIELDS SEARCHED (IPC)**

G03F

The present search report has been drawn up for all claims

| Place of search | Date of completion of the search | Examiner |
|---|---|---|
| Munich | 18 December 2024 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 6931

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2024

| Patent document cited in search report | | Publication date | Patent family member(s) | | Publication date |
|---|---|---|---|---|---|
| US 2011216294 | A1 | 08-09-2011 | CN | 102763040 A | 31-10-2012 |
| | | | IL | 221145 A | 28-02-2017 |
| | | | JP | 5554846 B2 | 23-07-2014 |
| | | | JP | 2013520019 A | 30-05-2013 |
| | | | KR | 20120132683 A | 07-12-2012 |
| | | | TW | 201142529 A | 01-12-2011 |
| | | | US | 2011216294 A1 | 08-09-2011 |
| | | | WO | 2011101183 A1 | 25-08-2011 |
| JP 2017215482 | A | 07-12-2017 | JP | 6761281 B2 | 23-09-2020 |
| | | | JP | 2017215482 A | 07-12-2017 |

EPO FORM P0459

For more details about this annex : see Official Journal of the European Patent Office, No. 12/82